# EUROPÄISCHE PATENTSCHRIFT

(11) **EP 3 645 979 B1**
(45) Veröffentlichungstag und Bekanntmachung des Hinweises auf die Patenterteilung: **02.03.2022**
(21) Anmeldenummer: 18726437.9
(22) Anmeldetag: 18.05.2018
(51) Int. Cl.: G01D 11/24

(54) **MESSSYSTEM**
MEASUREMENT SYSTEM
SYSTÈME DE MESURE

(30) Priorität: 29.06.2017 DE 102017114555
(43) Veröffentlichungstag der Anmeldung: 06.05.2020
(73) Patentinhaber: Endress+Hauser SE+Co. KG, 79689 Maulburg (DE)
(72) Erfinder: BECHTEL, Gerd, 79585 Steinen (DE); FERRARO, Franco, 79650 Schopfheim (DE); SCHMIDT, Robert, 79650 Schopfheim (DE); WERNET, Armin, 79618 Rheinfelden (DE)
(74) Vertreter: Andres, Angelika Maria
(86) Internationale Anmeldenummer: PCT/EP2018/063090
(87) Internationale Veröffentlichungsnummer: WO 2019/001846

(56) Entgegenhaltungen:
- EP-A1- 2 105 716
- EP-A1- 2 515 380
- DE-A1-102008 052 912
- DE-A1-102013 111 696
- DE-A1-102013 111 714
- DE-U1- 29 612 454

## Beschreibung

Die Erfindung betrifft ein Messsystem mit einem zur Bestimmung und/oder Überwachung einer Prozessgröße eines Mediums ausgestalteten Feldgerät der Automatisierungstechnik und mit einer Anschlusseinheit. Die Anschlusseinheit weist einen mit dem Feldgerät elektrisch verbundenen Anschlussstecker und ein Kabel auf, das mit einem Kabelanschluss an den Anschlussstecker angeschlossen ist. Das Kabel dient der Versorgung des Feldgeräts mit elektrischer Energie und/oder der Übertragung von Informationen zwischen dem Feldgerät und einer übergeordneten Einheit.

In der Automatisierungstechnik werden Feldgeräte zur Bestimmung und/oder Überwachung von Prozessgrößen eingesetzt. Als Feldgeräte werden im Rahmen der vorliegenden Anmeldung im Prinzip alle Messgeräte bezeichnet, die prozessnah eingesetzt werden und die prozessrelevante Informationen liefern oder verarbeiten. Dabei handelt es sich beispielsweise um Füllstandsmessgeräte, Durchflussmessgeräte, Druck- und Temperaturmessgeräte, pH-Redoxpotentialmessgeräte, Leitfähigkeitsmessgeräte, usw., welche die entsprechenden Prozessgrößen Füllstand, Durchfluss, Druck, Temperatur, pH-Wert bzw. Leitfähigkeit erfassen. Solche Feldgeräte werden in unterschiedlichen Ausgestaltungen von der E+H Gruppe hergestellt und vertrieben.

Derartige Feldgeräte, die auch in explosionsgefährdeten Bereichen betrieben werden sollen, beispielsweise in einer explosionsfähigen Staubatmosphäre, müssen sehr hohen Sicherheitsanforderungen hinsichtlich des Explosionsschutzes genügen. Dies wird z.B. verlangt, um konform zu den Anforderungen der europäischen ATEX Richtlinie zu sein.

Dabei geht es im Besonderen darum, die Bildung von Funken sicher zu vermeiden oder um zumindest sicherzustellen, dass ein im Fehlerfall entstandener Funke keine Auswirkungen auf die Umgebung hat. Im Zusammenhang mit dem Explosionsschutz wird zwischen verschiedenen Zündschutzarten unterschieden, die jeweils auch in einschlägigen, elektrische Betriebsmittel für explosionsgefährdete Bereiche betreffenden Standards und Normen manifestiert sind. Als eine Norm ist zum Beispiel die Zündschutzart Staub-Ex aufgeführt. Bei elektrischen Geräten, die gemäß dieser Schutzklasse ausgebildet sind, muss z.B basierend auf dem Gehäuseschutz sichergestellt sein, dass kein Staub in das Gehäuse eintreten kann, welcher ansonsten in Verbindung mit einer im Inneren des Gehäuses angeordneten Zündquelle wie etwa elektrischen Kontakten zu einer Explosion führen kann. Das Gehäuse muss hierfür also ausreichend dicht gegenüber Staub sein. Zusätzlich muss sichergestellt sein, dass das Gehäuse auch durch einen Schlag nicht derart beschädigt werden kann, dass es nicht mehr ausreichend dicht ist. Das Gehäuse muss also zusätzlich zur Dichtheit eine ausreichende mechanische Festigkeit aufweisen.

Um zu überprüfen, ob eine ausreichend hohe mechanische Festigkeit vorliegt, werden im Rahmen einer Konformitätsbewertung z.B. Schlagtests durchgeführt. Hierbei wird eine vorgegebene mechanischer Stoßenergie auf einen als Schwachstelle des Messsystem identifizierten Bereich eingebracht, indem ein Schlagtestkörper aus einer bestimmten Höhe auf eine Schwachstelle fallen gelassen wird. Zur Klassifizierung der Widerstandsfähigkeit von Gehäusen gegen Stoßbeanspruchung einer bestimmten Stoßenergie wird z.B. der IK-Stoßfestigkeitsgrad verwendet.

Hierbei wird die Anforderung bezüglich Dichtheit und mechanischer Festigkeit nicht nur an das prozessnah eingesetzte Feldgerät, sondern gegebenenfalls auch an das Messsystem, umfassend das Feldgerät und die Anschlusseinheit, gestellt.

Eine Möglichkeit ist es daher, das Messsystem von vornerein mit einer ausreichenden Dichtheit und mechanischer Festigkeit auszulegen, beispielsweise durch die Auswahl einer speziellen Dichtgeometrie und/oder der Auswahl eines entsprechenden Werkstoffes für die Anschlusseinheit.

Nachteilig an dieser Lösung ist, dass oftmals vorgegebene vorkonfektionierte oder konfektionierbare Anschlusseinheiten verwendet werden, oder dass sogar in einer Prozessanlage eines Anwenders bereits vorinstallierte Anschlusseinheiten vorhanden sind, auf weiche ein Anwender bevorzugt zurückgreift. Diese erfüllen zum Beispiel die Anforderungen an die Dichtheit, nicht aber jene an die mechanische Festigkeit. Insbesondere weist das Feldgerät selbst, d.h. ohne die Anschlusseinheit, typischerweise eine höhere Stoßfestigkeit als das Messsystem, umfassend das Feldgerät und die Anschlusseinheit auf. Ein Bereich von geringer Stoßfestigkeit wird also erst durch die Verwendung einer beliebigen Anschlusseinheit, insbesondere im Bereich des Anschlusssteckers, geschaffen. Daher besteht das Messsystem gegebenenfalls nicht den Schlagtest, so dass nach einem Schlag nicht mehr gewährleistet ist, dass das Messsystem ausreichend staubdicht ist.

Im Gebrauchsmuster DE 296 12 454 U1 ist ein wasserdichte Schutzvorrichtung zur Aufnahme eines Mess- oder Anzeigegeräts offenbart, welche aus zwei lösbar miteinander verbundenen Gehäuseteilen besteht.

In der Patentanmeldung EP 2 515 380 A1 ist ein Feldgerät für erhöhte Sicherheit beschrieben, sowie eine Abdeckung für einen Stecker.

Die Patentanmeldung EP 2 105 716 A1 beschreibt eine Schutzhaube mit einem Gehäuse zum Schützen eines Messgeräts. Die Schutzhaube ist einteilig ausgestaltet, wobei das Gehäuse in zwei Gehäuseabschnitte aufgeteilt ist, welche durch ein Kopplungselement verbunden sind.

In der Patentanmeldung DE 10 2013 111 696 A1 ist eine Anschlussvorrichtung für ein Feldgerät offenbart. Eine Abdeckklappe deckt einen Steckverbinder zumindest teilweise ab.

Der Erfindung liegt daher die Aufgabe zugrunde, eine Lösung anzugeben, um in einem Messsystem, insbesondere lokal, die mechanische Festigkeit des Messsystems zu erhöhen.

Die Aufgabe wird gelöst durch ein Messsystem mit einem zur Bestimmung und/oder Überwachung einer Prozessgröße eines Mediums ausgestalten Feldgerät der Automatisierungstechnik; mit einer Anschlusseinheit, die einen mit dem Feldgerät elektrisch verbundenen Anschlussstecker und ein Kabel aufweist, das mit einem Kabelanschluss an den Anschlussstecker angeschlossen ist und das der Versorgung des Feldgeräts mit elektrischer Energie und/oder der Übertragung von Informationen zwischen dem Feldgerät und einer übergeordneten Einheit dient;
und mit einer Schutzhaube, die die Anschlusseinheit und das mit der Anschlusseinheit verbundene Feldgerät in einem Schutzabschnitt zum Schutz des Messsystems im Schutzabschnitt umgibt, wobei mittels der Schutzhaube die Stoßfestigkeit des Messsystems in dem Schutzabschnitt derart eingestellt ist, dass das Messsystem in dem Schutzabschnitt eine bestimmte vorgebbare Stoßfestigkeit aufweist.

Mittels der Schutzhaube wird das Messsystem also nachträglich in ein Messsystem von erhöhter Stoßfestigkeit umgewandelt, unabhängig von der jeweiligen Ausgestaltung der Anschlusseinheit selbst. Hierzu umgibt die Schutzhaube die Anschlusseinheit und das mit der Anschlusseinheit verbundene Feldgerät in dem Schutzabschnitt zumindest teilweise. Durch die zusätzliche Verwendung der Schutzhaube kann damit für das Messsystem eine vorgebbare Stoßfestigkeit erreicht werden, insbesondere eine vergleichbare Stoßfestigkeit wie für das Feldgerät, erreicht werden. Mittels der Ausgestaltung der Schutzhaube wird eine höhere, insbesondere z.B. eine vorgebbare, Stoßfestigkeit des Messsystems in dem Schutzabschnitt erreicht. Der Schutzabschnitt ist dabei ein lokaler Bereich zumindest eines Teils der Anschlusseinheit und des daran angeschlossenen Feldgeräts.

Der Vorteil der erfindungsgemäßen Lösung ist, dass die Anforderungen an die Dichtheit und an die Stoßfestigkeit voneinander entkoppelt werden. Die Dichtheit kann z.B. mittels der Ausgestaltung der Anschlusseinheit sichergestellt sein, ohne dass an die Anschlusseinheit zusätzliche Einschränkungen durch Anforderungen an die Stoßfestigkeit bestehen. Dadurch können Anschlusseinheiten mit einer beliebigen Stoßfestigkeit verwendet werden. Da die Stoßfestigkeit mittels der zusätzlichen Schutzhaube erreicht wird, ist damit insgesamt die Dichtheit des Messsystems, auch unter Einwirkung eines Schlags, gewährleistet. Dadurch erfüllt das erfindungsgemäße Messsystem eine Staub-Ex-Zündschutzklasse, welche ein ansonsten identisch ausgestaltetes Messsystem ohne Schutzhaube gegebenenfalls nicht erfüllt.

Erfindungsgemäß ist der Anschlussstecker mit dem Feldgerät in einen Verbindungsbereich verbunden, der in Bezug auf einen Prozessanschluss des Feldgeräts auf der dem Prozess abgewandten Seite des Prozessanschlusses angeordnet ist. In der dem Prozess abgewandten bzw. zugewandten Seite des Prozessanschlusses liegen gegebenenfalls unterschiedliche Anforderungen bezüglich sicherheitsrelevanter Normen vor.

In einer weiteren Ausgestaltung der Erfindung erstreckt sich der Schutzabschnitt zumindest von dem Verbindungsbereich bis zu dem Kabelanschluss. Damit umfasst der Schutzabschnitt zumindest den Anschlussstecker und seine Verbindung mit dem Feldgerät bzw. mit dem Kabelanschluss. Da das Kabel selbst flexibel ist, ist der sich an den Kabelanschluss angrenzende Bereich des Kabels unempfindlich gegenüber Stoßbeanspruchungen.

Der Schutzabschnitt liegt insbesondere auf der dem Prozess abgewandten Seite des Prozessanschlusses. Die Schutzhaube ist also nur auf der dem Prozess abgewandten Seite des Prozessanschlusses angeordnet. Damit dient die erfindungsgemäße Schutzhaube also nicht dem Schutz des dem Prozess ausgesetzten Abschnitt des Feldgeräts. Bei diesem Abschnitt handelt es sich etwa um eine mit dem Prozess in Berührung kommende sensitive Einheit des Feldgeräts, welcher z.B. anhand einer völlig anderen Schutzhaube vor durch den Prozess bedingte chemisch-physikalischer Beanspruchung geschützt ist.

In einer vorteilhaften Weiterbildung der Erfindung erstreckt sich der Schutzabschnitt über einen Bereich, der größer ist als der von dem Verbindungsbereich und dem Kabelanschluss begrenzte Bereich.

Insbesondere jedoch erstreckt sich der Schutzabschnitt über einen Bereich, der um maximal 100% größer ist als der von dem Verbindungsbereich und dem Kabelanschluss begrenzte Bereich. Vorzugsweise erstreckt sich der Schutzabschnitt über einen Bereich, der um maximal 50% größer ist als der von dem Verbindungsbereich und dem Kabelanschluss begrenzte Bereich.

Der Schutzabschnitt ist also insbesondere doppelt und vorzugsweise 1,5 mal so groß wie der Bereich, der durch den Anschlussstecker und seine Verbindung mit dem Feldgerät bzw. mit dem Kabelanschluss begrenzt ist. In dieser vorteilhaften Weiterbildung ist also insbesondere zusätzlich eingeschränkt, inwiefern der Schutzabschnitt lokal begrenzt ist bzw. in welchem Ausmaß die Schutzhaube nur einen Bereich des Messsystems schützt, welcher an den Anschlussstecker lokal angrenzt.

In einer weiteren Ausgestaltung der Erfindung ist der Anschlussstecker mit dem Feldgerät dadurch elektrisch verbunden, dass Anschlusspins des Feldgeräts in den Anschlussstecker gesteckt sind. Die Anschlusspins dienen daher zumindest der elektrischen Verbindung von Anschlussstecker und Feldgerät. Gegebenenfalls dienen die Anschlusspins zusätzlich auch der mechanischen Verbindung. Es können jedoch auch weitere mechanische Mittel zur Verbindung im Verbindungsbereich vorgesehen sein.

Erfindungsgemäß ist die Schutzhaube derart ausgestaltet, dass sie von dem Messsystem lösbar ist. Dadurch ist die Schutzhaube insbesondere wiederholt auf- bzw. absetzbar und insbesondere auch auswechselbar. Hierdurch wird ein besonders hoher Modularisierungsgrad erreicht, da --je nach aktuellen Bedürfnissen bzw. Anforderungen an das Messsystem -- die Stoßfestigkeit in dem Schutzabschnitt mittels der Schutzhaube auf einen bestimmten, beispielsweise vorgebbaren Wert, eingestellt werden kann. Insbesondere ist es einfach, ein bestehendes Messsystem in einer bestehenden Prozessanalage bei sich erhöhenden Anforderungen an die Stoßfestigkeit entsprechend nachzurüsten; insbesondere ist auch ein Austausch einer ersten Schutzhaube durch eine zweite, stabilere Schutzhaube ohne weiteres möglich.

In einer Ausgestaltung der Erfindung weist die Schutzhaube zumindest zwei miteinander mechanisch verbindbare Teile auf. Es handelt sich also um eine mehrteilige Schutzhaube. Insbesondere handelt es sich um ineinander verschraubbare und/oder steckbare Teile.

In einer dazu alternativen Ausgestaltung der Erfindung ist die Schutzhaube einteilig.

Erfindungsgemäß ist die Schutzhaube mit einem an einem Endbereich des Schutzabschnitts angeordnetem Gewinde des Feldgerätes mit dem Feldgerät verschraubbar. Mittels des Gewindes an dem Feldgerät ist die Schutzhaube mit dem Feldgerät verbunden.

In einer Ausgestaltung der Erfindung besteht die Schutzhaube aus einem Metall. Metallische Werkstoffe sind aufgrund ihre Stabilität bevorzugt.

In einer weiteren Ausgestaltung der Erfindung besteht die Schutzhaube aus einem Kunststoff.

In einer besonders bevorzugten Weiterbildung weist das Feldgerät eine in dem Schutzabschnitt angeordnete Anzeigeeinheit auf, die zur Anzeige von Statusinformationen und/oder der Prozessgröße ausgestaltet ist. Im einfachsten Fall wird beispielsweise ein Schaltstatus des Feldgeräts an der Anzeigeeinheit angezeigt.

Für den Fall, dass eine derartige Anzeigeeinheit im Schutzabschnitt angeordnet ist, ist es wünschenswert, wenn die Anzeigeeinheit auch unter Verwendung der die Anzeigeeinheit umgebende Schutzhaube weiterhin sichtbar ist.

In einer Ausgestaltung weist die Schutzhaube daher Aussparungen auf, mittels derer zumindest die Anzeigeeinheit sichtbar ist.

In einer weiteren Ausgestaltung weist die Schutzhaube zumindest im Bereich der Anzeigeeinheit ein transparentes Material auf. Selbstverständlich kann die Schutzhaube auch vollständig aus einem transparenten Werkstoff, beispielsweise einem transparenten Kunststoff, bestehen. Dadurch ist die Anzeigeeinheit durch die Schutzhaube hindurch sichtbar, unabhängig davon, ob die Schutzhaube Aussparungen aufweist. Auch etwa ein Typenschild ist bei einer transparenten Schutzhaube sichtbar.

Ein weiterer Vorteil einer vollständig transparenten Schutzhaube ist, dass die Ex-Norm hier kleinere Schlagenergien in den Schlagfestigkeitstests vorsieht: eine transparente Schutzhaube muss prinzipiell nur bis zu einer kleineren Schlagenergie standhalten, beispielsweise 4J anstelle von 7J. Dadurch ergeben sich aufgrund der Transparenz prinzipiell geringere Anforderungen an die mechanische Festigkeit, und damit auch eine größere Freiheit an die Wahl des Materials für die transparente Schutzhaube.

In einer vorteilhaften Weiterbildung weist die Schutzhaube ein Gewinde auf, mit welchem ein das Kabel vollständig umgebendes, insbesondere metallisches, Rohr verschraubbar ist. Eine Möglichkeit zur sogenannten "Verrohrung" des Kabels wird in einigen Prozessanlagen aufgrund von sicherheitsrelevanten Anforderungen an das Messsystem gestellt. Zusätzlich zum Schutz des Messsystems im Schutzabschnitt wird durch die Verwendung der Schutzhaube also gleichzeitig die Möglichkeit zur Verrohrung geschaffen.

In einer weiteren Weiterbildung der Erfindung wird mittels der Erhöhung der Stoßfestigkeit in dem Schutzabschnitt das Messsystem eine Schutzklasse erfüllt, die ein ansonsten identisch ausgestaltetes Messsystem ohne Schutzhaube nicht erfüllt.

Die Erfindung wird anhand der nachfolgenden, nicht maßstabsgetreuen Figuren näher erläutert, wobei gleiche Bezugszeichen gleiche Merkmale bezeichnen. Wenn es die Übersichtlichkeit erfordert oder es anderweitig sinnvoll erscheint, wird auf bereits erwähnte Bezugszeichen in nachfolgenden Figuren verzichtet. Es zeigt:
Fig. 1: Eine schematische Schnittansicht einer Ausgestaltung des erfindungsgemäßen Messsystems;
Fig. 2: Eine Explosionsdarstellung einer weiteren Ausgestaltung eines erfindungsgemäßen Messsystems.

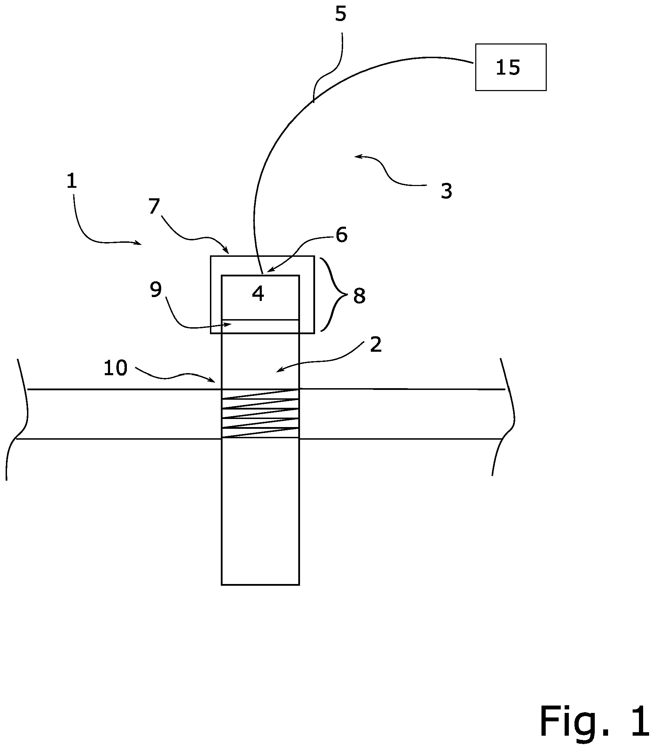

Fig. 1 zeigt eine schematische Schnittansicht eines Messsystems 1, mit einem über einen Prozessanschluss 10 z.B. in eine Behälter- oder Rohrleitungswand eingebauten Feldgerät 2. Das Feldgerät 2 umfasst in diesem Ausführungsbeispiel als eine für die zumindest eine Prozessgröße sensitive Sensoreinheit hier nicht näher dargestellte mechanische schwingfähige Einheit, etwa eine Schwinggabel oder eine Membran, wobei dieses Beispiel selbstverständlich keineswegs beschränkend für die Erfindung ist.

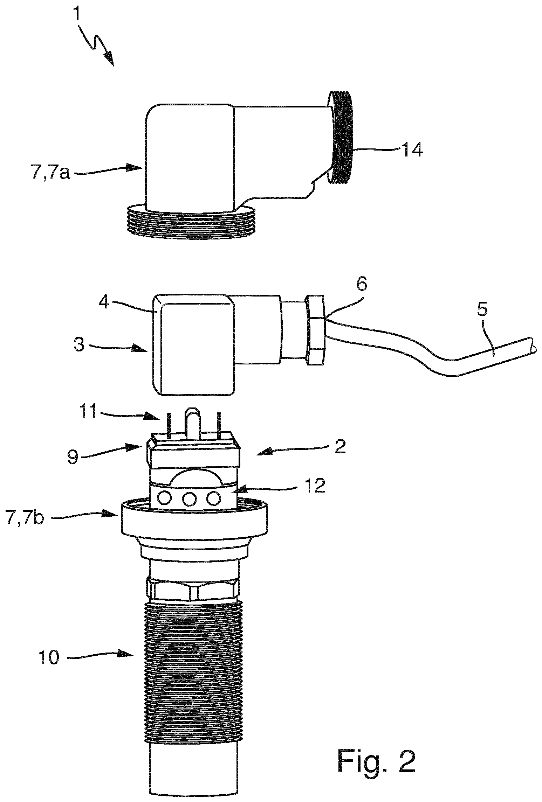

Die Anschlusseinheit 3 ist in dem Verbindungsbereich 9 des Feldgeräts 2 mit dem Feldgerät elektrisch und mechanisch verbunden. Die Anschlusseinheit 3 umfasst dabei einen Anschlussstecker 4, wobei die elektrische Verbindung zwischen dem Anschlussstecker 4 und dem Feldgerät 2 mittels der in Fig. 2 näher gezeigten Anschlusspins 11 des Feldgeräts 2 und dem Anschlussstecker 4 der Anschlusseinheit 3 erfolgt. Die Anschlusseinheit 3 umfasst ferner ein mit einem Kabelanschluss 6 an den Anschlussstecker 4 angeschlossenes (d.h. elektrisch und mechanisch verbundenes) Kabel 5.

Die Anschlusseinheit 3 ist z.B. als eine vorkonfektionierte M12 Steckereinheit d.h. mit einem M12 Gewinde ausgebildet, oder auch als eine andere Anschlusseinheit 3 mit einem Gewinde mit einer anderen Gewindegröße. Durch das Gewinde des Anschlusssteckers 4 wird eine zusätzliche mechanische Verbindung im Verbindungsbereich 9 mit dem Feldgerät 2 hergestellt.

Das Kabel 5 kann z.B. Teil ein 4-20mA Messübertragungsstrecke sein, über welche das Feldgerät 2 mit Energie versorgt wird und gleichzeitig der Wert der Prozessgröße als ein Stromwert von dem Feldgerät 2 zu einer übergeordneten Einheit 15 übertragen werden. Das Kabel 5 kann dabei auch Teil eines drahtgebundenen Kommunikationsnetzwerk sein, mittels dem wie in Fig. 1 schematisch dargestellt Informationen bezüglich der Prozessgröße und Statusinformationen des Feldgeräts 2 an die übergeordnete Einheit 15 übermittelt werden. Bei der übergeordneten Einheit 15 handelt es sich beispielsweise um eine in einer Leitwarte angeordnete speicherprogrammierte Steuerungseinheit (SPS).

Bei dem Kommunikationsnetzwerk kann es sich zum Beispiel um einen drahtgebundenen Feldbus der Automatisierungstechnik, beispielsweise Foundation Fieldbus, Profibus PA, Profibus DP, HART, CANBus, etc. handeln, oder aber auch um ein modernes industrielles Kommunikationsnetzwerk, beispielsweise um einen "Industrial Ethernet"-Feldbus, insbesondere Profinet, HART-IP oder Ethernet/IP oder um ein aus dem Kommunikationsbereich bekanntes Kommunikationsnetzwerk, beispielsweise Ethernet nach dem TCP/IP-Protokoll.

Das Feldgerät 2 an sich weist eine ausreichend hohe mechanische Festigkeit auf, um wie eingangs erläutert für den Einsatz in explosionsgefährdeten Bereichen zugelassen zu werden.

Durch die Verwendung einer vorgegeben z.B. standardisierten oder schon vorinstallierten Anschlusseinheit 3 mit einem Anschlussstecker 4 aus einem vorgegebenen Werkstoff kann das Messsystem 1, umfassend das Feldgerät 2 und die Anschlusseinheit 3 jedoch nicht die für den Einsatz im explosionsgefährdeten Bereichen notwendige mechanische Festigkeit erreichen. Insbesondere stellt z.B. der Verbindungsbereich 9 zwischen Anschlussstecker 4 und Feldgerät 2 eine Schwachstelle dar, welche typischerweise in einer Konformitätsbewertung mit Schlagtests auf die Stoßfestigkeit hin untersucht wird.

Durch die Verwendung der aufsetzbaren Schutzhaube 7 wird die Stoßfestigkeit des Messsystems in einem Schutzabschnitt 8 erhöht. Der Schutzabschnitt 8 erstreckt sich dabei über einen Bereich, welcher leicht größer ist als der durch den Kabelanschluss 6 und den Verbindungsbereich 9 begrenzte Bereich. Die Schutzhaube 7 ist hier als einteilig dargestellt, kann aber, siehe Fig. 2, auch mehrteilig ausgeführt sein. In diesem Beispiel ist die einteilige Schutzhaube 7 mit einem nicht näher dargestellten Gewinde 13 des Feldgeräts 2 verschraubt, das an einem dem Prozessanschluss 10 zugewandten Endbereich des Schutzabschnitts 8 angeordnet ist.

Mittels der Schutzhaube 7 wird daher lokal in dem Schutzabschnitt 8 die Stoßfestigkeit des Messsystems 1 erhöht. Hierdurch erfüllt insbesondere das Messsystem 1 eine Ex-Staub Zündschutzklasse, die ein ansonsten identisch ausgestaltetes Messsystem 1 ohne Schutzhaube 7 nicht erfüllt.

Bevorzugt ist die Schutzhaube 7 wiederholt aufsetzbar bzw. lösbar. Damit handelt es sich also um eine modulares Messsystem 1, welches durch das nachträgliche Aufsetzten bzw. Entfernen der Schutzhaube 7 an aktuell vorliegende oder sich ändernde Anforderungen des Explosionsschutzes angepasst wird.

Die Stoßfestigkeit wird dabei insbesondere durch die Wahl des Werkstoffes der Schutzhaube 7 erreicht. Es eignen sich z.B. metallische Werkstoffe, aber z.B. auch Werkstoffe aus einem Kunststoff mit einer ausreichend hohen mechanischen Beständigkeit, wie etwa einen thermoplastischen oder duroplatischen Kunststoff.

In Fig. 2 ist in einer Explosionsdarstellung eine weitere Ausgestaltung eines erfindungsgemäßen Messsystems 1 dargestellt, wobei die schon in Fig. 1 beschriebenen Merkmale nicht näher erläutert werden.

In diesem Ausführungsbeispiel handelt es sich bei dem Anschlussstecker 4 einen sogenannten Ventilstecker, weicher auf die in dem Verbindungsbereich 9 angeordneten Anschlusspins 11 des Feldgeräts 2 gesteckt wird. Unterhalb des Verbindungsbereichs 9 weist das Feldgerät 2 eine Anzeigeeinheit 12 auf, welche im Schutzabschnitt 8 angeordnet ist.

Die Anzeigeeinheit 12 umfasst hier drei farbige LEDs, mittels derer z.B. im Fall eines als Grenzstandschalter ausgebildeten Feldgeräts 2 mit einer mechanisch schwingfähigen Einheit der Schaltstatus und ggf. weitere Statusinformationen angezeigt werden. Als Statusinformationen kann z.B. an der Anzeigeeinheit 12 angezeigt werden, ob eine Fehlfunktion der mechanisch schwingfähigen Einheit vorliegt, wie etwa Ansatz an der mechanisch schwingfähigen Einheit und/oder weitere aus dem Stand der Technik bekannte Fehlfunktionen.

In diesem Beispiel handelt es sich bei der Schutzhaube 7 um eine mehrteilig ausgeführte Schutzhaube 7 mit zwei ineinander verschraubbaren Teilen 7a,7b. Bei einem ersten Teil 7b der Schutzhaube 7 handelt es sich um eine Überwurfmutter.

Die Schutzhaube 7 ist hier aus einem vollständig transparenten Werkstoff, so dass an der Anzeigeeinheit 11 angezeigte Informationen trotz Schutzhaube 7 weiterhin sichtbar sind. Selbstverständlich ist es auch möglich, die Schutzhaube 7 nur als teilweise transparent auszulegen, beispielsweise indem nur die Überwurfmutter 7b aus einem transparenten Werkstoff besteht.

Alternativ kann die Schutzhaube 7 auch im Bereich der Anzeigeeinheit 11 Aussparungen aufweisen, mittels derer die Anzeigeeinheit 11 weiterhin sichtbar ist, beispielsweise im Falle einer vollständig metallischen Schutzhaube 7.

Die Schutzhaube 7 wird auf das Messsystem 1 während des Zusammenstecken des Messsystems 1 aufgesetzt. Dabei wird in einem ersten Schritt z.B. der als Überwurfmutter ausgebildete erste Teil 7b der Schutzhaube 7 auf das Feldgerät 2 gesetzt. Anschließend wird die Anschlusseinheit 3 durch den zweiten Teil 7a der Schutzhaube geführt; hierfür muss die Schutzhaube selbstverständlich entsprechend dimensioniert sein. Anschließend wird der Anschlussstecker 4 mit dem Feldgerät 2 in dem Verbindungbereich 9 des Feldgeräts 2 verbunden, indem dir Anschlussstecker auf die Anschlusspins gesteckt wird. Im letzten Schritt werden die beiden Teile 7a,7b der Schutzhaube 7 miteinander verschraubt. Selbstverständlich ist es auch möglich, dass die beiden Teile 7a,7b der Schutzhaube 7 ineinander gesteckt sind, oder auf eine weitere aus dem Stand der Technik bekannte Art miteinander mechanisch verbunden sind. Bevorzugt sind dabei im Rahmen der Erfindung lösbare mechanische Verbindungen, gegenüber z.B. einem Löten oder Schweißen, damit die Schutzhaube 7 wiederholt aufsetzbar und damit vom Messsystem 1 lösbar ist.

Die Schutzhaube 7 weist in diesem Ausführungsbeispiel weiterhin in einem dem Kabel zugewandten Endbereich ein Gewinde auf. In dieses Gewinde ist z.B. eine zusätzliche, insbesondere metallische, Rohrleitung einschraubbar mit der das Kabel, zumindest in einem sich an den Kabelanschluss 6 angrenzenden Abschnitt des Kabels, zusätzlich geschützt werden kann. Diese zusätzliche Möglichkeit zur sogenannten Verrohrung ist in einigen Prozessanlagen aufgrund von sicherheitsrelevanten Anforderungen gewünscht.

### Bezugszeichen und Symbole

- 1: Messsystem
- 2: Feldgerät
- 3: Anschlusseinheit
- 4: Anschlussstecker
- 5: Kabel
- 6: Kabelanschluss
- 7: Schutzhaube
- 8: Schutzabschnitt
- 9: Verbindungsbereich
- 10: Prozessanschluss
- 11: Anschlusspins
- 7a,7b: Teile der Schutzhaube
- 12: Anzeigeeinheit
- 13,14: Gewinde
- 15: übergeordnete Einheit

## Patentansprüche

1. Messsystem (1),
- mit einem zur Bestimmung und/oder Überwachung einer Prozessgröße eines Mediums ausgestalten Feldgerät (2) der Automatisierungstechnik;
- mit einer Anschlusseinheit (3), die einen mit dem Feldgerät (2) elektrisch verbundenen Anschlussstecker (4) und ein Kabel (5) aufweist, das mit einem Kabelanschluss (6) an den Anschlussstecker (4) angeschlossen ist und das der Versorgung des Feldgeräts (2) mit elektrischer Energie und/oder der Übertragung von Informationen zwischen dem Feldgerät (2) und einer übergeordneten Einheit (15) dient;
wobei der Anschlussstecker (4) mit dem Feldgerät (2) in einen Verbindungsbereich (9) verbunden ist, der in Bezug auf einen Prozessanschluss (10) des Feldgeräts (2) auf der dem Prozess abgewandten Seite des Prozessanschlusses (10) angeordnet ist; und
- mit einer Schutzhaube (7), die die Anschlusseinheit (3) und das mit der Anschlusseinheit (3) verbundene Feldgerät (2) in einem Schutzabschnitt (8) zum Schutz des Messsystems (1) im Schutzabschnitt (8) umgibt, wobei die Schutzhaube (7) derart ausgestaltet ist, dass sie von dem Messsystem (1) lösbar ist,
wobei mittels der Schutzhaube (7) die Stoßfestigkeit des Messsystems (1) in dem Schutzabschnitt (8) derart eingestellt ist, dass das Messsystem (1) in dem Schutzabschnitt (8) eine bestimmte vorgebbare Stoßfestigkeit aufweist, und wobei die Schutzhaube (7) mit einem an einem Endbereich des Schutzabschnitts (8) angeordnetem Gewinde des Feldgerätes (2) mit dem Feldgerät (2) verschraubbar ist.

2. Messsystem (1) nach Anspruch 1,
wobei sich der Schutzabschnitt (8) zumindest von dem Verbindungsbereich (9) bis zu dem Kabelanschluss (6) erstreckt.

3. Messsystem (1) nach zumindest einem der vorherigen Ansprüche
wobei der Anschlussstecker (4) mit dem Feldgerät (2) dadurch elektrisch verbunden ist, dass Anschlusspins (11) des Feldgeräts (2) in den Anschlussstecker (4) gesteckt sind.

4. Messsystem (1) nach zumindest einem der vorherigen Ansprüche,
wobei die Schutzhaube (7) zumindest zwei miteinander mechanisch verbindbare, insbesondere ineinander verschraubbare und/oder steckbare, Teile (7a,7b) aufweist.

5. Messsystem (1) nach zumindest einem der vorherigen Ansprüche 1 bis 3, wobei die Schutzhaube (7) einteilig ist.

6. Messsystem (1) nach zumindest einem der vorherigen Ansprüche, wobei die Schutzhaube (7) aus einem Metall besteht.

7. Messsystem (1) nach zumindest einem der Ansprüche 1-5, wobei die Schutzhaube (7) aus einem Kunststoff besteht.

8. Messsystem (1) nach zumindest einem der vorherigen Ansprüche,
wobei das Feldgerät (2) eine in dem Schutzabschnitt (8) angeordnete Anzeigeeinheit (12) aufweist, die zur Anzeige von Statusinformationen und/oder der Prozessgröße ausgestaltet ist.

9. Messsystem (1) nach Anspruch 8,
wobei die Schutzhaube (7) Aussparungen aufweist, mittels derer zumindest die Anzeigeeinheit (12) sichtbar ist.

10. Messsystem (1) nach Anspruch 8-9, wobei die Schutzhaube (7) zumindest im Bereich der Anzeigeeinheit (12) ein transparentes Material aufweist.

11. Messsystem (1) nach zumindest einem der vorherigen Ansprüche,
wobei die Schutzhaube (7) ein weiteres Gewinde (14) aufweist, mit welchem ein das Kabel (5) vollständig umgebendes, insbesondere metallisches, Rohr verschraubbar ist.

12. Messsystem (1) nach zumindest einem der vorherigen Ansprüche,
wobei mittels der Schutzhaube (7) das Messsystem (1) eine Schutzklasse erfüllt, die ein ansonsten identisch ausgestaltetes Messsystem ohne Schutzhaube (7) nicht erfüllt.

## Claims

1. Measuring system (1),
- with a field device (2) used in automation technology and designed to determine and/or monitor a process variable of a medium;
- with a connection unit (3) which has a connection plug (4) electrically connected to the field device (2) and a cable (5) which is connected to the connection plug (4) via a cable connection (6), and which serves to supply electrical energy to the field device (2) and/or to transmit information between the field device (2) and a higher-level unit (15);
wherein the connection plug (4) is connected to the field device (2) in a connection area (9) which, in relation to a process connection (10) of the field device (2), is arranged on the side of the process connection (10) facing away from the process; and
- with a protective hood (7) which surrounds the connection unit (3) and the field device (2) connected to the connection unit (3) in a protection section (8), wherein said hood is designed to protect the measuring system (1) in the protection section (8), wherein the protective hood (7) is designed in such a way that it can be detached from the measuring system (1),
wherein, with the protective hood (7), the resistance of the measuring system (1) to shock in the protection section (8) is regulated in such a way that the measuring system (1) has a certain predefinable shock resistance in the protection section (8), and wherein the protective hood (7) can be screwed to the field device (2) with a thread of the field device (2) that is arranged at an end section of the protection section (8).

2. Measuring system (1) as claimed in Claim 1,
wherein the protection section (8) extends at least from the connection area (9) as far as the cable connection (6).

3. Measuring system (1) as claimed in at least one of the previous claims, wherein the connection plug (4) is electrically connected to the field device (2) in such a way that connection pins (11) of the field device (2) are plugged into the connection plug (4).

4. Measuring system (1) as claimed in at least one of the previous claims, wherein the protective hood (7) has at least two parts (7a, 7b) that can be connected mechanically with one another, particularly which can be screwed and/or plugged into one another.

5. Measuring system (1) as claimed in at least one of the previous claims 1 to 3, wherein the protective hood (7) is a single piece.

6. Measuring system (1) as claimed in at least one of the previous claims, wherein the protective hood (7) is made of metal.

7. Measuring system (1) as claimed in at least one of the Claims 1 to 5, wherein the protective hood (7) is made of plastic.

8. Measuring system (1) as claimed in at least one of the previous claims, wherein the field device (2) has a display unit (12) that is arranged in the protection section (8), wherein said unit is designed to display status information and/or the process variable.

9. Measuring system (1) as claimed in Claim 8,
wherein the protective hood (7) has recesses via which at least the display unit (12) is visible.

10. Measuring system (1) as claimed in Claim 8 to 9,
wherein the protective hood (7) features a transparent material at least in the area of the display unit (12).

11. Measuring system (1) as claimed in at least one of the previous claims,
wherein the protective hood (7) has another thread (14) with which it is possible to screw in a tube, particularly a metal tube, which completely surrounds the cable (5).

12. Measuring system (1) as claimed in at least one of the previous claims,
wherein, by means of the protective hood (7), the measuring system (1) meets the requirements of a protection class, which an otherwise identical measuring system without a protective hood (7) does not meet.

## Revendications

1. Système de mesure (1),
- avec un appareil de terrain (2) de la technique d'automatisation conçu pour déterminer et/ou surveiller une grandeur de process d'un produit ;
- avec une unité de raccordement (3) qui présente un connecteur de raccordement (4) relié électriquement à l'appareil de terrain (2) et un câble (5) qui est raccordé à la fiche de raccordement (4) par une connexion de câble (6), et laquelle unité sert à alimenter l'appareil de terrain (2) en énergie électrique et/ou à transmettre des informations entre l'appareil de terrain (2) et une unité supérieure (15) ;
le connecteur de raccordement (4) étant relié à l'appareil de terrain (2) dans une zone de raccordement (9) qui est disposée, par rapport à un raccord process (10) de l'appareil de terrain (2), sur le côté du raccord process (10) opposé au process ; et
- avec un capot de protection (7) qui entoure l'unité de raccordement (3) et l'appareil de terrain (2) relié à l'unité de raccordement (3) dans une section de protection (8), lequel capot est destiné à protéger le système de mesure (1) dans la section de protection (8), le capot de protection (7) étant conçu de telle sorte à pouvoir être détaché du système de mesure (1),
la résistance aux chocs du système de mesure (1) dans la section de protection (8) étant réglée au moyen du capot de protection (7) de telle sorte que le système de mesure (1) présente dans la section de protection (8) une certaine résistance aux chocs prédéfinissable, et le capot de protection (7) pouvant être vissé à l'appareil de terrain (2) au moyen d'un filetage de l'appareil de terrain (2) disposé dans une zone d'extrémité de la section de protection (8).

2. Système de mesure (1) selon la revendication 1,
pour lequel la section de protection (8) s'étend au moins depuis la zone de raccordement (9) jusqu'à la connexion de câble (6).

3. Système de mesure (1) selon au moins l'une des revendications précédentes, pour lequel le connecteur de raccordement (4) est relié électriquement à l'appareil de terrain (2) par le fait que des broches de raccordement (11) de l'appareil de terrain (2) sont enfichées dans le connecteur de raccordement (4).

4. Système de mesure (1) selon au moins l'une des revendications précédentes, pour lequel le capot de protection (7) présente au moins deux parties (7a, 7b) pouvant être reliées mécaniquement entre elles, notamment pouvant être vissées et/ou enfichées l'une dans l'autre.

5. Système de mesure (1) selon au moins l'une des revendications précédentes 1 à 3,
pour lequel le capot de protection (7) est d'une seule pièce.

6. Système de mesure (1) selon au moins l'une des revendications précédentes, pour lequel le capot de protection (7) est constitué d'un métal.

7. Système de mesure (1) selon au moins l'une des revendications 1 à 5, pour lequel le capot de protection (7) est constitué d'une matière plastique.

8. Système de mesure (1) selon au moins l'une des revendications précédentes, pour lequel l'appareil de terrain (2) présente une unité d'affichage (12) disposée dans la section de protection (8), laquelle unité est configurée pour afficher des informations d'état et/ou la grandeur de process.

9. Système de mesure (1) selon la revendication 8,
pour lequel le capot de protection (7) présente des évidements au moyen desquels au moins l'unité d'affichage (12) est visible.

10. Système de mesure (1) selon la revendication 8 à 9,
pour lequel le capot de protection (7) présente un matériau transparent au moins dans la zone de l'unité d'affichage (12).

11. Système de mesure (1) selon au moins l'une des revendications précédentes, pour lequel le capot de protection (7) présente un autre filetage (14) avec lequel peut être vissé un tube, notamment métallique, entourant complètement le câble (5).

12. Système de mesure (1) selon au moins l'une des revendications précédentes, pour lequel, au moyen du capot de protection (7), le système de mesure (1) satisfait à un indice de protection auquel ne satisfait pas un système de mesure sans capot de protection (7), présentant par ailleurs une configuration identique.
